# FASCICULE DE BREVET EUROPEEN

(11) **EP 2 376 671 B1**
(45) Date de publication et mention de la délivrance du brevet: **29.11.2017**
(21) Numéro de dépôt: 09799671.4
(22) Date de dépôt: 17.12.2009
(51) Int. Cl.: C23C 16/02, C23C 16/27, B23B 27/14

(54) **PROCÉDÉ DE FABRICATION DE MATÉRIAUX COMPOSITES DIAMANTES**
VERFAHREN ZUR HERSTELLUNG VON DIAMANTVERBUNDWERKSTOFFEN
METHOD FOR MAKING DIAMOND COMPOSITE MATERIALS

(30) Priorité: 19.12.2008 FR 0807181
(43) Date de publication de la demande: 19.10.2011
(73) Titulaire: Centre National de la Recherche Scientifique, 75016 Paris (FR)
(72) Inventeur: MANAUD, Jean-Pierre, F-33450 Saint-Loubes (FR); POULON, Angéline, F-33460 Arsac (FR); TEULE-GAY, Lionel, F-33000 Bordeaux (FR); FAURE, Cyril, F-24310 Bourdeilles (FR)
(74) Mandataire: Gevers & Orès
(86) Numéro de dépôt international: PCT/FR2009/001440
(87) Numéro de publication internationale: WO 2010/076423

(56) Documents cités:
- EP-A- 0 445 305
- CN-A- 1 827 846
- DATABASE WPI Week 199346 Thomson Scientific, London, GB; AN 1993-365068 XP002544218 & JP 05 270982 A (IDEMITSU PETROCHEM CO) 19 octobre 1993 (1993-10-19) & JP 05 270982 A 19 octobre 1993 (1993-10-19)
- MANAUD ET AL: "A comparative study of CrN, ZrN, NbN and TaN layers as cobalt diffusion barriers for CVD diamond deposition on WC-Co tools" SURFACE AND COATINGS TECHNOLOGY, ELSEVIER, AMSTERDAM, NL, vol. 202, no. 2, 18 octobre 2007 (2007-10-18), pages 222-231, XP022303112 ISSN: 0257-8972

## Description

La présente invention a pour objet un procédé de dépôt d'un revêtement diamanté sur un support, ce procédé conduisant à l'obtention d'un revêtement caractérisé par une nouvelle morphologie du diamant sous forme de pyramides constituées de grains sub microniques. L'invention a également pour objet les revêtements et les articles obtenus par ce procédé.

Les matériaux composites comprenant un support ou substrat sur lequel est déposée une couche de diamant ou de carbone diamanté sont connus depuis longtemps.

De tels matériaux sont obtenus habituellement par dépôt chimique en phase vapeur (ou CVD) d'atomes de carbone sur le substrat. Les méthodes permettant de mettre en oeuvre le procédé CVD pour l'obtention de revêtements diamantés sont décrites dans : B.V. Spitsyn et al., J. of Crystal Growth 52 (1981), 219-26 et S. Matsumoto et al., J. of Materials Science 17 (1982), 3106-12. Le document J.-P. Manaud et al., Surface & Coatings Technology 202 (2007), 222-231 décrit la formation de germes de diamant obtenus sans polarisation du substrat qui ont conduit à la formation de microcristaux cubo-octahédriques. La taille de ces cristaux varie de quelques microns à quelques dizaines de microns. Toutefois, ces matériaux ne sont pas dépourvus d'inconvénients : le diamant est composé de carbone tétrahédrique covalent à liaison très forte hybridée sp³. De ce fait, les germes présentent peu d'aptitude à créer des liaisons de nature chimique avec les substrats. Les tensions internes du revêtement, la mauvaise adhérence du revêtement au substrat et la différence des propriétés thermomécaniques entre le revêtement et le substrat ont pour conséquence une grande fragilité de ces matériaux.

Or ces matériaux sont conçus pour être utilisés dans des secteurs très sensibles comme la fabrication d'outils pour l'usinage de matériaux composites destinés à l'aéronautique, et ces matériaux composites sont fortement abrasifs et destructifs pour l'outil de coupe. Ils peuvent aussi être employés comme implants dans le domaine biomédical, ou encore ils peuvent être utilisés comme outils en odontologie. Leur utilisation a également été proposée dans le domaine du génie chimique comme joints mécaniques pour le pompage de liquides corrosifs grâce à la grande inertie chimique du diamant.

Dans toutes ces applications, une fiabilité élevée des matériaux diamantés est attendue, mais les procédés connus actuellement ne permettent pas d'obtenir le résultat souhaité.

En particulier, en ce qui concerne la fabrication d'outils pour l'usinage de matériaux composites, ceux-ci sont extrêmement abrasifs si bien que les arêtes des outils sont érodées et arrondies dès les premiers contacts avec le matériau. Il s'ensuit un échauffement local qui accélère la destruction de l'outil et endommage la surface usinée (fusion locale, délaminage...). La protection de la surface des outils de coupe est donc incontournable. Le diamant est un matériau de choix puisqu'il est réputé pour être le plus dur présent dans la nature. Ces dernières années sont apparus des outils traités MCD (Diamant Micro Cristallin) et plus récemment NCD (Diamant Nano Cristallin). Le premier traitement s'est très rapidement caractérisé par son manque de fiabilité. Le deuxième, plus performant n'atteint cependant pas les propriétés des outils PCD (Diamant Poly Cristallin : cristaux de diamant enrobés). Malheureusement la fabrication de ces derniers pour certains types d'outils comme les forets ou les fraises de petits diamètres demeure à ce jour inexistante parce que techniquement difficile et économiquement très onéreuse.

Et en particulier, dans le cas des outils à base de carbure de tungstène-cobalt (WC-Co) qui sont employés pour l'usinage de pièces en matériaux hautement abrasifs tels que des alliages métalliques non ferreux, des composites et des céramiques, la présence de cobalt dans le substrat (généralement entre 6 et 10%) a une influence négative sur le procédé de dépôt de diamant. La présence de Co favorise la formation de phases carbonées non diamantées, c'est-à-dire pour l'essentiel de graphite, ce qui entraîne une faible adhésion du revêtement diamanté sur le substrat.

Pour résoudre ce problème, différentes méthodes ont été proposées, en vue d'améliorer la qualité du revêtement diamanté et son adhésion au substrat : le décapage chimique qui appauvrit le substrat en cobalt à sa surface, et le dépôt d'une barrière de diffusion. Toutefois, aucune de ces méthodes n'est suffisante pour remédier entièrement au problème.

Le schéma réactionnel pour le dépôt d'un revêtement diamanté comporte trois étapes : initiation, germination et croissance.

Dans les procédés habituellement employés, dans l'étape de germination, la sursaturation en carbone (G. Cicala et al., Diamond & Related Materials 14 (2005), 421-425 ; S.J. Askari et al., Vacuum 81 (2007), 713-717; S.J. Askari et al., Diamond & Related Materials 17 (2008), 294-299) en l'absence de champ électrique se traduit par un accroissement de la présence d'espèces graphitiques (sp²) et donc une diminution de l'adhérence des germes de diamant (sp³) (F.A. Almeida et al., Vacuum 81 (2007), 1443-1447).

Certains auteurs (H. Sein et al., Diamond & Related Materials 13 (2004), 610-615; H. Li et al., Diamond & Related Materials 16 (2007), 1918-1923) ont proposé de mettre en oeuvre conjointement une sursaturation en carbone et un champ électrique dans l'étape de germination, de façon à obtenir une densité de germination très élevée, un accroissement de l'adhérence des germes et donc une meilleure adhésion du revêtement. Mais ces propriétés doivent encore être améliorées pour satisfaire les exigences liées aux applications des matériaux à revêtement diamanté.

Les documents CN 1827846 et JP 19920071435 décrivent un procédé permettant la croissance de films de diamant. Ce procédé comporte une étape dite de nucléation, ou germination, sous un champ électrique de voltage négatif et une étape de dépôt ou croissance sous un champ électrique de voltage positif. Ce procédé conduit à la formation de diamant micro grains dont la morphologie et la texturation sont très proches de celles obtenues par croissance en l'absence de champ électrique.

Et l'objectif de l'invention a été de surmonter les problèmes de l'art antérieur en mettant au point un procédé de dépôt de diamant sur un substrat, ce procédé permettant d'obtenir un revêtement ayant une adhésion au substrat supérieure à celle obtenue par les procédés de l'art antérieur.

Un premier objet de l'invention est un procédé de dépôt de diamant sur un substrat, par CVD, ou dépôt chimique en phase vapeur, ce procédé comprenant au moins :
a) une étape d'initiation,
b) une étape de germination,
c) une étape de croissance, l'étape de croissance comportant au moins une séquence de deux phases successives, la première phase étant une phase de coalescence sans application de champ électrique et la seconde phase étant une phase de germination secondaire par application d'un champ électrique, avantageusement par application d'un champ électrique négatif.

L'invention s'applique à des substrats variés choisis en fonction de l'application concernée :
- du carbure de tungstène-cobalt (WC-Co),
- du titane Ti, ou un alliage de titane (TA6V ou Ti-6Al-4V, Ti-Nb....),
- une céramique telle que : Si₃N₄, TiC, SiC et autres carbures,
- des wafers de silicium habituellement employés dans l'industrie microélectronique.

De façon préférentielle, le substrat est choisi parmi : un carbure de tungstène-cobalt (WC-Co), du titane, un alliage de titane.

De façon préférentielle, pour l'usinage des matériaux composites, le substrat est un carbure de tungstène-cobalt (WC-Co) comprenant de 4 à 14 % en masse de cobalt.

Avantageusement, le substrat est préparé, avant sa mise en oeuvre dans le procédé de dépôt de diamant, par application d'un traitement choisi parmi : un décapage mécanique et un décapage chimique.

De préférence, le substrat est tout d'abord soumis à un décapage mécanique et ensuite éventuellement à un décapage chimique.

Lorsque le substrat est un WC-Co comprenant de 4 à 6 % de Co, après dégraissage, on prévoit avantageusement un décapage mécanique (un traitement par projection de microbilles de corindon par exemple) suivi d'un décapage chimique du substrat avant la mise en oeuvre du procédé de l'invention. Selon cette variante, on réduit la teneur en cobalt au voisinage de la surface par gravure chimique : les substrats de carbure de tungstène sont décapés dans un bain basique puis rincés à l'eau et plongés dans un bain H₂SO₄/H₂O₂ de manière à appauvrir la surface en cobalt. Ils sont ensuite rincés et plongés dans une solution alcoolisée sous ultrasons contenant des grains de diamant.

Lorsque le substrat est un WC-Co comprenant de 6 à 14 % de Co, on prévoit avantageusement un décapage mécanique du substrat avant la mise en oeuvre du procédé de l'invention : De façon connue, on peut prévoir que préalablement au dépôt les supports soient soumis à un traitement par projection de microbilles d'une matière dure sous pression, puis nettoyés. On peut par exemple projeter sur la surface des microbilles de corindon.

De façon connue, pour assurer la germination, la croissance et l'adhérence du diamant, et afin d'éviter la présence à la surface du substrat d'espèces comme le cobalt induisant la formation de graphite (sp²) au détriment de celle du diamant (sp³), on peut prévoir de déposer une barrière de diffusion sur le substrat, avant l'étape a) du procédé de dépôt de diamant.

Conformément à l'enseignement de l'art antérieur (J.P. Manaud et al., Surface and Coatings Technology, volume 202, Issue 2, 25 Novembre 2007, p.222-231) le matériau choisi pour la couche barrière de diffusion peut être choisi parmi : des nitrures de niobium (NbN), de tantale (TaN), de Hafnium (HfN) et de zirconium (ZrN). Ils peuvent être déposés en couches de faible épaisseur (par exemple de 0,5 à 1 micron) en tant que barrière de diffusion au cobalt lors des dépôts de diamant jusqu'à 900°C. Durant le dépôt du diamant, NbN et TaN se transforment en carbures NbC et TaC alors que ZrN et HfN sont préservés. Elles nécessitent le dépôt additif d'une couche métallique de germination dans laquelle la dissolution du carbone est appropriée pour permettre une germination massive (P-O Joffreau et al., MRS Spring Films, 5-9 Avril 1988, Reno, Nevada). C'est le cas par exemple du molybdène (Yuan-Sheng Huang et al., Thin Solid Films, volume 472, Issues 1-2, 24 janvier 2005, p. 20-25) qui favorise donc la germination rapide du diamant. Les mêmes méthodes permettent d'obtenir des barrières de nitrure d'hafnium HfN tout aussi efficaces que ZrN.

Les barrières de nitrure de tantale, niobium, zirconium ou hafnium sont déposées à des températures comprises entre 400 et 500°C par pulvérisation cathodique réactive d'une cible métallique pour les substrats plans. L'azote est ajouté comme gaz réactif. Pour des substrats de forme plus complexe comme les forets et les fraises, il existe des machines industrielles de pulvérisation cathodique équipées de dispositifs spéciaux permettant un dépôt uniforme.

Les nitrures de zirconium et de niobium peuvent également être obtenus par RPAE (évaporation assistée par plasma réactif) pour des formes complexes comme les forets ou les fraises. Pour cette technique le métal est évaporé au canon à électrons à partir d'une source métallique. L'azote est ajouté comme gaz réactif soit sous forme de di-azote, ou mieux sous forme d'azote neutre ou monoatomique radicalaire via une source surfatron à post décharge d'un plasma micro-ondes. Comme dans tous les processus réactifs à basse pression, les vitesses d'évaporation et les pressions partielles des gaz sont des paramètres dépendants qui doivent être rigoureusement contrôlés et optimisés pour chaque procédé et pour chaque machine de dépôt.

Ces contrôles font partie des ajustements que l'homme du métier peut faire à partir des modes opératoires décrits ci-dessous dans la partie expérimentale.

Avantageusement, le procédé de l'invention comprend une étape de dépôt d'une couche de germination et d'accrochage après le dépôt d'une barrière de diffusion. La couche de germination et d'accrochage est constituée, de façon connue, d'un métal destiné à se carburer. Cette étape comporte le dépôt d'un métal, qui peut être choisi parmi : Mo, W, Cr, Fe, Ti, Zr, Hf, Nb, Ta... à condition que le nitrure de ce métal ne soit pas thermochimiquement plus stable que celui du métal constituant la barrière. Dans le cas contraire il pourrait, par simple élévation de la température, réagir avec la barrière de diffusion et la détruire.

Sur la barrière de diffusion, le métal destiné à se carburer durant la phase initiale de diamantage est déposé par les mêmes méthodes que le dépôt de la couche barrière de diffusion. La vitesse de diffusion du carbone dans ce métal et son carbure est déterminante pour les phases de germination et de coalescence du diamant (MRS Spring Films, 5-9 Avril 1988, Reno, Nevada, P-O Joffreau *et al*.). Les germes de diamant se forment à partir du moment où la dissolution du carbone est suffisamment lente. De ce fait, il est impératif que la couche d'accrochage soit rapidement saturée en carbone et que la barrière de diffusion ne se carbure pas (cas de ZrN) ou bien se carbure suffisamment lentement (cas de TaN et NbN) pour à la fois éviter la diffusion du cobalt et pour assurer la germination rapide du diamant.

La couche métallique est déposée par le même procédé que celui utilisé pour élaborer la barrière de diffusion, c'est-à-dire soit par pulvérisation cathodique, soit par évaporation assistée par plasma (non réactif dans ce cas). L'épaisseur de la couche de germination et d'accrochage est avantageusement comprise entre 100 et 400 nm, de préférence entre 200 et 300 nm.

Le substrat choisi, préparé ou non conformément aux étapes qui ont été décrites ci-dessus, est ensuite soumis à un procédé de dépôt de diamant par CVD, ce procédé comportant au moins :
a) une étape d'initiation,
b) une étape de germination,
c) une étape de croissance,
qui vont être décrites de façon détaillée ci-dessous.

Le traitement CVD peut être fait dans tout type de réacteur et notamment : un réacteur CVD à plasma micro-onde (MWPCVD) ou un réacteur CVD à filaments chauds (HFCVD). Dans les deux cas, le procédé requiert une polarisation électrique négative du substrat à revêtir. Dans le cadre d'un développement industriel, on préfère la mise en oeuvre du procédé sur un réacteur à filaments chauds dont la stabilité et la fiabilité de fonctionnement sont plus facilement assurées sous champ électrique.

### Initiation :

Lorsque l'on utilise un réacteur MWCVD ou HFCVD, l'étape d'initiation consiste à porter le substrat à une température comprise entre 700 et 900°C, de préférence entre 800 et 900 °C, sous un plasma hyperfréquence d'hydrogène pur ou d'un mélange d'hydrogène et d'un gaz rare pendant une durée comprise entre 10 et 30 minutes sous un champ électrique d'un potentiel continu de -100V à- 350V.

Dans le cas de la MWCVD le plasma hyperfréquence est un plasma d'hydrogène pur ou d'un mélange d'hydrogène et d'un gaz rare (He, Ne, Ar), appliqué pendant une durée comprise entre 10 et 30 minutes, de préférence entre 15 et 30 minutes sous un champ électrique d'un potentiel continu de - 100V à - 350 V, en particulier dans le cas du MWCVD de -100 V à - 250V. Avantageusement, la densité de puissance est comprise entre 0,5 et 3 W/cm². De préférence le potentiel est d'environ -200V, dans le cas du MWCVD, et la densité de puissance d'environ 1 W/cm².

Le plasma hyperfréquence a une double fonction : la création d'espèces neutres radicalaires et le chauffage du substrat par rayonnement. Sous de telles conditions, la surface est nettoyée, désoxydée et activée chimiquement par création de liaisons pendantes.

Dans le procédé utilisant la HFCVD, la température très élevée des filaments permet de briser les liaisons des molécules réactives pour obtenir des espèces radicalaires. Un faible pourcentage de gaz rare (He, Ne, Ar) peut être ajouté pour aider à amorcer et maintenir un plasma dû à la polarisation négative des substrats. La valeur de ce pourcentage dépend du gaz rare utilisé et de la géométrie des équipements du réacteur. De même la tension et la puissance du champ électrique appliquées peuvent dépendre de la géométrie et de la taille du réacteur. Dans le réacteur de laboratoire qui a été utilisé pour la mise en oeuvre de l'invention, la tension est comprise entre -150 et - 300V pour une densité de puissance comprise entre 10 et 25 W/cm². La durée de l'étape d'initiation est identique à celle du procédé MWCVD.

### Germination :

La germination massive est obtenue par sursaturation en carbone de la surface du substrat à la même température et comporte l'application d'un champ électrique d'un potentiel continu de - 100V à -350 V, et en particulier dans le cas du MWCVD de - 100 V à - 250V, pendant une durée comprise entre 20 et 60 minutes, avantageusement entre 30 et 60 minutes. Avantageusement, la densité de puissance est comprise entre 0,5 et 2 W/cm². De préférence le potentiel est d'environ -200V, dans le cas du MWCVD, et la densité de puissance d'environ 1 W/cm².

Pour ce faire le plasma d'hydrogène de l'étape d'initiation est remplacé par un plasma d'un mélange H₂/CH₄/X, dans lequel X représente un gaz rare ou neutre, avec un pourcentage en volume de gaz rare ou neutre par rapport au volume total du mélange compris entre 0 et 20% selon le gaz et avec un pourcentage en volume de CH₄ par rapport au volume total du mélange compris entre 3 et 4 %, de préférence environ 3%. Le gaz rare ou neutre X peut être choisi par exemple parmi : l'hélium, le néon, l'argon, l'azote ou un mélange de ces gaz.

Dans cette étape, la fonction du champ électrique négatif est de créer un plasma dont les ions positifs bombardent la surface. Ceci a pour effet de multiplier les sites de germination secondaires, de pulvériser les espèces peu adhérentes particulièrement sur les aspérités de surface et de les redéposer collatéralement. Cet effet de bombardement peut être accru par l'ajout d'une faible proportion de gaz rare. L'avantage est que les réactions à la surface sont extrêmement activées par la présence de neutres radicalaires (radicaux méthyle et hydrogène par exemple).

De l'effet conjugué de la sursaturation et du champ électrique (H. Sein et al., Diamond & Related Materials 13 (2004), 610-615; H. Li et al., Diamond & Related Materials 16 (2007), 1918-1923), résulte une densité de germination très élevée et un accroissement de l'adhérence des germes les moins adhérents puisque d'une part les germes les moins adhérents ont été pulvérisés préférentiellement et d'autre part des atomes du substrat peuvent être pulvérisés sous l'effet du bombardement par des ions positifs issus du plasma. Comme la pression est relativement élevée, le libre parcours moyen est très court et ces atomes peuvent se redéposer sur le substrat, créant ainsi une interface de pseudo diffusion entre le substrat et le diamant. C'est un avantage lorsqu'on utilise une barrière de diffusion surtout si on choisit comme métal des éléments présentant un rendement de pulvérisation relativement élevé comme le chrome, le germanium, le molybdène, le zirconium, le hafnium, le niobium, le tantale ou le tungstène. Ces processus sont bien connus des spécialistes des traitements de surface par les plasmas froids et par les dépôts ioniques.

### Croissance :

L'étape de croissance, de préférence à une température comprise entre 800 et 900°C, se décompose en 2 séquences et permet in fine d'obtenir des pyramides constituées essentiellement, et de manière originale, de nano grains de diamant. Elle comporte des phases alternées, d'une durée comprise entre 20 et 40 minutes, de préférence environ 30 minutes chacune, de coalescence sans champ électrique appliqué puis de gravure sous champ électrique, avantageusement négatif.

Avantageusement, les phases alternées de coalescence sans champ électrique puis de gravure sous champ électrique négatif sont mises en oeuvre dans les conditions suivantes :
- durée de chaque phase comprise entre 20 et 40 minutes,
- application d'un plasma d'un gaz choisi parmi :
   - un mélange H₂/CH₄/X dans lequel X représente un gaz rare ou neutre, avec un pourcentage en volume de gaz rare ou neutre par rapport au volume total du mélange compris entre 0 et 10 % et avec un pourcentage en volume de CH₄ par rapport au volume total du mélange compris entre 0,5 et 1,5 %,
   - un mélange de H₂/CH₄/CO₂, volume du mélange CH₄/CO₂ par rapport au volume total des gaz compris entre 0,5 et 5% pour un rapport des volumes de CH₄/CO₂ compris entre 0,2 et 0,8
   - un mélange CH₄/CO₂ avec un rapport des volumes de CH₄/CO₂ compris entre 0,4 et 0,6
- le débit total des gaz étant supérieur à 10 cm³/min, et la pression comprise entre 1 et 60 hPa.

De façon avantageuse, selon une première variante, on applique un plasma d'un mélange H₂/CH₄/X, dans lequel X représente un gaz rare ou neutre avec un pourcentage en volume de gaz rare ou neutre par rapport au volume total du mélange compris entre 0 et 10 % et avec un pourcentage en volume de CH₄ par rapport au volume total du mélange compris entre 0,5 et 1,5 %, de préférence entre 0,8 et 1,2 %. Le gaz rare ou neutre X peut être choisi par exemple parmi : de l'argon, du néon, de l'hélium, de l'azote, ou un mélange de ces gaz. Dans notre réacteur de laboratoire, le débit total est avantageusement compris entre 200 et 500 cm³/min. Dans un autre réacteur, notamment à l'échelle industrielle, l'homme du métier adapterait ces paramètres en fonction des indications données ci-dessous et dans la partie expérimentale.

Selon une seconde variante, on emploie un mélange choisi parmi H₂/CH₄/CO₂ ou CH₄/CO₂, de préférence à des pressions comprises entre 5 et 40 hPa et pour des débits compris, dans notre réacteur de laboratoire, entre 10 et 150 cm³/min. Dans un autre réacteur, notamment à l'échelle industrielle, l'homme du métier adapterait ces paramètres en fonction des indications données ci-dessous et dans la partie expérimentale.

Dans tous les cas le débit d'entrée des gaz précurseurs dans le réacteur dépend étroitement de la vitesse d'évacuation des produits de la réaction et donc de la puissance du groupe de pompage. De ce fait, le bon équilibre consiste à maintenir le réacteur, de préférence, sous régime d'écoulement laminaire à des pressions comprises entre 5 et 40 hPa susceptibles d'assurer :
- Un équilibre correct du plasma selon le procédé CVD utilisé,
- Une vitesse de croissance du diamant acceptable pour un procédé industriel,
- La morphologie pyramidale nano cristalline (Pyr NCD) escomptée.

La première phase de coalescence, sans application d'un champ électrique, débute donc juste après l'étape de germination. Durant cette phase, la taille des germes s'accroît et les grains formés peuvent coalescer librement.

A la fin de cette phase, on applique les mêmes conditions que dans l'étape de coalescence quant aux conditions d'atmosphère gazeuse (mélange de gaz, débit) et en outre, on applique un champ électrique de potentiel continu négatif. Avantageusement on applique un champ électrique d'un potentiel continu compris entre-100V et -350 V, et en particulier dans le cas du MWCVD de -100 V à -250 V. Avantageusement la densité de puissance est comprise entre 1,5 et 15 W/cm² pendant la durée de cette phase, le potentiel de préférence de -140V à -200V dans le cas du MWCVD, et avantageusement environ -200V dans le cas du MWCVD, pour une densité de puissance comprise entre 2 et 12 W/cm² selon la géométrie du réacteur et la taille des échantillons à traiter.

Le plasma ainsi créé « grave » par pulvérisation les germes précédemment coalescés. Des atomes de carbone sont arrachés et d'autres sont apportés par le mélange gazeux induisant ainsi une nouvelle sursaturation locale en carbone au voisinage de la surface. Les conditions d'une germination secondaire sont donc à nouveau réunies pendant la durée de cette phase après laquelle le champ électrique sera à nouveau coupé.

Le procédé de l'invention comprend au moins une séquence de deux phases successives, l'une étant une phase de coalescence sans application de champ électrique et la seconde étant une phase de gravure et de germination par application d'un champ électrique, avantageusement par application d'un champ électrique négatif.

Après la phase de gravure, une nouvelle phase de coalescence est alors appliquée. Le processus peut continuer ainsi jusqu'à obtenir une couche continue. Ce processus se traduit par deux effets dont la combinaison confère au dépôt final une morphologie inédite : d'une part la gravure due au champ électrique limite la croissance unidirectionnelle du diamant orthogonalement à la surface, d'autre part la germination secondaire induit la taille nanométrique des grains de diamant. Enfin, on observe une morphologie pyramidale d'amas de nano grains de diamant, liée à l'érosion séquentielle. En parallèle, il y a coalescence des germes au voisinage des pyramides préalablement formées ce qui a pour effet d'élargir leur base et d'augmenter la surface de contact avec le substrat ou la barrière. Les effets de gravure peuvent être accentués par l'ajout éventuel d'une faible concentration d'argon pour une gravure dure ou d'un autre gaz (néon ou azote..) pour une gravure plus douce. Cela favorise 1- la nucléation secondaire du diamant pour former des nano grains mais ne modifie pas la morphologie pyramidale 2-l'adhérence des pyramides de nano grains de diamant par accroissement de leur surface de base et par création d'une interface pseudo-diffusée due au bombardement ionique et au redépôt des espèces.

De façon avantageuse, cette séquence est répétée autant de fois que nécessaire pour obtenir l'épaisseur souhaitée de la couche. L'épaisseur obtenue à chaque séquence dépend du réacteur employé et l'homme du métier sait, à partir d'essais portant sur quelques séquences, ajuster le nombre de séquences appliquées en fonction de l'épaisseur désirée.

Dans le réacteur micro onde expérimental conçu et réalisé dans notre laboratoire, une application de 1 à 5 séquences de ces deux phases donne une couche de diamant discontinue, tandis qu'à partir de 6 séquences, on obtient une couche continue d'épaisseur de l'ordre de 1 à 4 microns.

Une épaisseur raisonnable pour un outil de coupe se situe entre 2 et 4 microns. Au-delà, les contraintes résiduelles sont telles qu'elles favorisent le délaminage.

De façon avantageuse, on prévoit donc de déposer une couche de diamant d'une épaisseur comprise entre 2 et 4 µm.

Dans le cas d'un dépôt dans un réacteur CVD à filaments chauds, certaines conditions de dépôt décrites ci-dessus doivent être respectées. Les filaments (tungstène ou tantale) portés à haute température (1 800 à 3 000°C) remplacent alors le plasma micro-onde pour créer les espèces radicalaires. Les substrats doivent être polarisés et chauffés à une température comprise entre 700 et 900°C, sous un plasma d'hydrogène pur ou d'un mélange tel que ceux décrits ci-dessus pendant une durée comprise entre 10 et 30 minutes sous un champ électrique d'une tension continue comprise entre - 120V et - 350V. Les précurseurs gazeux sont les mêmes, en revanche les pressions et les débits sont modifiés en adéquation avec la géométrie des constituants du réacteur.

Les couches de diamant obtenues présentent un niveau de contrainte beaucoup plus faible que celui des couches de diamant connues dans l'art antérieur, ce qui limite les problèmes de délaminage. La durée nécessaire du dépôt pour obtenir une couche continue ou d'une épaisseur donnée est un paramètre dépendant de la géométrie du réacteur. De ce fait elle doit être adaptée à l'outil industriel existant.

De façon avantageuse, le procédé de l'invention comprend en outre une étape supplémentaire d'enrobage tribologique.

L'enrobage tribologique du diamant est conçu pour assurer deux fonctions qui doivent être optimisées selon l'application envisagée pour l'outil. La première fonction de l'enrobage est, par remplissage des espaces intergranulaires, de renforcer la cohésion de la couche en bloquant latéralement les cristallites les unes par rapport aux autres. Ceci augmente la résistance aux efforts tangentiels sur la couche et peut accroître la résistance aux chocs. La deuxième fonction de l'enrobage est d'assurer le meilleur glissement possible de la surface de l'outil sur le matériau usiné. Les propriétés requises pour cet enrobage sont d'avoir un module de Young moyen de manière à assurer une rigidité suffisante, tout en étant suffisamment tenace et plastique pour ne pas être cassant. Il doit être relativement inerte chimiquement aux températures d'usinage, notamment vis-à-vis de l'oxygène. Il doit également avoir un coefficient de glissement aussi faible que possible vis-à-vis du matériau potentiellement usiné. En conclusion, ce matériau d'enrobage est choisi en fonction de la finalité de l'outil et de la température à laquelle il doit travailler. Pour les usinages à température modérée (alliage d'aluminium, métaux non ferreux...), le DLC (mélange de carbone graphitique sp² et de carbone de type diamant sp³), les nitrures ou carbonitrures de chrome, titane, zirconium, hafnium, le di-borure de titane conviennent parfaitement. Pour les usinages abrasifs ou à des températures plus élevées, l'alumine Al₂O₃ présente un réel intérêt de par sa résistance à l'oxydation, ce qui de plus protège le diamant très sensible à l'oxydation.

Ce nouveau procédé apporte une amélioration notable dans la fabrication des dépôts de diamant nano grain. Il est simple de mise en oeuvre et permet d'utiliser des équipements déjà employés pour cette application avec une simple adaptation facilement réalisable. De préférence, la machine de dépôt classique de CVD micro onde ou de CVD à filament chaud est munie d'un dispositif de polarisation des substrats par application informatisée du champ électrique.

L'application discontinue du champ électrique durant la phase de croissance de la couche crée artificiellement des périodes de renucléation sans pour autant augmenter la concentration en précurseur carboné dans la phase gazeuse, ce qui limite la présence d'espèces graphitiques et donc favorise l'adhérence du diamant.

La morphologie du revêtement peut être modulée à loisir allant d'une simple juxtaposition d'îlots de pyramides jusqu'à une couche continue.

Ce procédé peut être employé avec les techniques de préparation de surface des carbures largement utilisées à ce jour ou avec des techniques plus sophistiquées telle celle exposée dans la partie descriptive. Il permet aussi un traitement tribologique ou décoratif ultérieur.

Les revêtements obtenus par le procédé de l'invention sont nouveaux et constituent un autre objet de l'invention.

En particulier, l'invention a pour objet un article comportant un substrat tel que décrit ci-dessus sur lequel se trouve une couche de nanograins de diamant de forme pyramidale.

La structure morphologique de la couche de nanograins de diamant assemblés en agrégats pyramidaux peut être caractérisée par microscopie électronique à balayage, par microscopie électronique à transmission, par diffraction aux rayons X et par spectroscopie Raman.

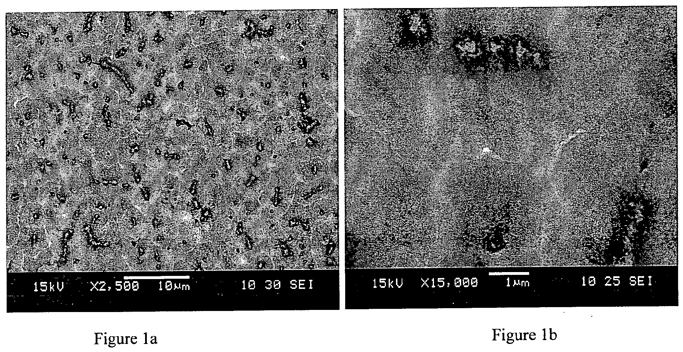

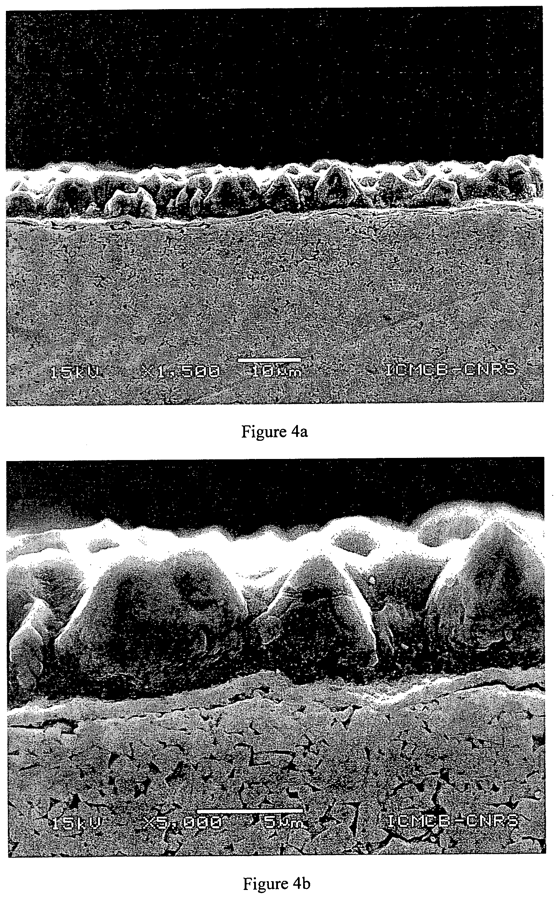

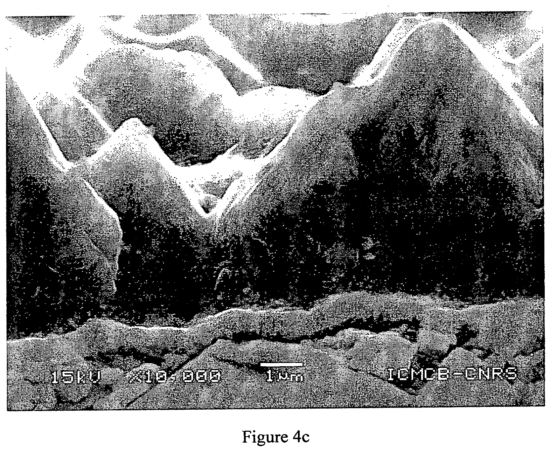

La couche de diamant obtenue se présente sous la forme de pyramides de taille micronique à bases planes constituées essentiellement de nano grains de diamant, c'est-à-dire de grains de diamant dont la taille, définie par le diamètre des grains, peut aller de 1 à 100 nm, ce qui constitue une morphologie inédite du diamant déposé sur une surface rugueuse d'un multi matériau composite comme le montrent les photos de microscopie à balayage (figures 1a, 1b et 4a, 4b, 4c). De plus cette couche peut être discontinue ou continue selon la durée du procédé ce qui ouvre la voie à un traitement de surface complémentaire à fonction tribologique (hyperglissement) ou décorative (code couleur par exemple).

Contrairement aux procédés de l'art antérieur, le procédé de l'invention donne accès à des couches d'agrégats pyramidaux de grains de diamant de taille nanométrique, soit de grains de diamant dont la taille est comprise entre quelques nanomètres et quelques dizaines de nanomètres et ces nano grains de diamant peuvent être déposés de façon à former une couche continue, d'épaisseur inférieure à un micron, alors que les procédés de l'art antérieur ne permettaient pas d'obtenir de couche continue de diamant d'épaisseur inférieure à un micron.

Du fait de leurs interfaces pseudo-diffusées et de la base élargie et continue des agrégats pyramidaux les matériaux de l'invention ont une adhésion et une résistance à l'effort tangentiel accrues. Ceci favorise une meilleure résistance au délaminage de la couche diamant.

### PARTIE EXPERIMENTALE

### Figures :

Fig. 1a et 1b : Photographies de microscopie électronique à balayage (vue de dessus) d'un substrat revêtu d'une couche de nanograins de diamant de structure pyramidale (PyrNCD).
Fig. 2 : Spectre de spectroscopie Raman déconvolué d'un substrat revêtu d'une couche de nanograins de diamant de structure pyramidale (PyrNCD)..
Fig. 3 : Spectre de diffraction X sous incidence de 2,5° d'un substrat revêtu d'une couche de nanograins de diamant de structure pyramidale (PyrNCD) et d'une barrière de diffusion de nitrure de tantale transformée en carbure de tantale lors du dépôt de diamant.
Fig. 4a, 4b, 4c : Photographies de microscopie électronique à balayage (vue en coupe) montrant les grains de carbure de tungstène du cermet WC-Co ; l'interface barrière, la couche d'accrochage et les pyramides de diamant.

Les dépôts de diamant ont été effectués dans un réacteur micro-onde réalisé dans notre laboratoire. Il est constitué d'un tube de quartz de 50 mm de diamètre placé orthogonalement dans le guide d'onde et évacué par une pompe à vide. Le porte-substrat constitué d'un disque en inox 304 de 12 mm de diamètre peut être polarisé négativement par un générateur de tension continue dont la valeur peut être variée de 0 à -250V via une alimentation filtrée. Le courant peut être mesuré à tout moment.

Les précurseurs utilisés sont de l'hydrogène et du méthane préalablement mélangés par des débitmètres massiques permettant le mélange et la régulation des flux de gaz. De l'argon ou un autre gaz rare tel de l'hélium ou du néon peut être ajouté en faible proportion durant les phases d'initiation et de germination pour accroître les effets de pulvérisation du substrat et favoriser la création d'une interface pseudo diffusée.

D'autres précurseurs ont été utilisés comme des mélanges H₂/CH₄/CO₂. La pression durant le dépôt a été optimisée à 40 hPa pour un débit total de 450 cm³/min. La température mesurée par un pyromètre optique bi bande peut être fixée entre 700 et 900°C.

Le schéma réactionnel comporte 3 étapes : initiation, germination et croissance.

Les substrats qui ont été employés sont des plaquettes de 15x15 mm² de cermets de WC-Co contenant de 6 à 10% de cobalt, de marque Teledyne, nuances K 10 ; P 30 M et P 40 M. Ont également été employés des disques de 1 à 4 mm d'épaisseur découpés dans des barreaux K40 UF de carbure WC-10%Co de 16 mm de diamètre servant de matière première à la fabrication industrielle de fraises et de forets.

### - Réalisation d'un outil de coupe traité avec du diamant PyrNCD

### 1- Dépôt de PyrNCD sur substrat WC-6%Co après décapage chimique

### a- Réparation des substrats :

Les supports sont microbillés pendant quelques secondes dans les conditions suivantes :
- pression d'air : 200 kPa,
- microbilles de corindon ; taille moyenne : 50 microns,
- distance entre la buse et les substrats : 10 cm.

Les supports ont ensuite été nettoyés par ultrasons dans de l'acétone et lavés de toute impureté à la vapeur d'alcool isopropylique.

On réduit ensuite la teneur en cobalt au voisinage de la surface par gravure chimique : les substrats de carbure de tungstène sont décapés dans un bain basique puis rincés à l'eau et plongés dans un bain H₂SO₄/H₂O₂ pendant 15 secondes de manière à appauvrir la surface en cobalt. Ils sont ensuite rincés et plongés dans une solution alcoolisée sous ultrasons contenant des grains de 1 micron de diamant.

### b- Dépôt de diamant:

Le dépôt de PyrNCD est effectué comme développé ci-après en 2-d ; 2-e et 2-f.

### 2- Dépôt de PyrNCD sur substrat WC riches en Co (≥6%)

Pour l'usinage de matériaux composites, on utilise des outils dont le support est en carbure de tungstène. Les plus courants contiennent actuellement 6% à 12% de cobalt. L'efficacité de la barrière telle qu'elle est proposée ci-après est indépendante de la teneur en cobalt, cette dernière valeur n'est donc pas limitative. En revanche, compte tenu de la température relativement élevée du dépôt de diamant (700-900°C), il est préférable d'éviter l'addition de tout élément pouvant conduire à la formation de carbures mixtes par décarburation du carbure de tungstène tel le titane et le tantale à cause de la fragilisation du support que cela induirait.

### a- Préparation des substrats

Préalablement au dépôt les supports sont microbillés pendant quelques secondes sous les conditions suivantes :
- pression d'air : 200 kPa,
- microbilles de corindon; taille moyenne : 50 microns,
- distance entre la buse et les substrats : 10 cm.

Les supports ont ensuite été nettoyés par ultrasons dans de l'acétone et lavés de toute impureté à la vapeur d'alcool isopropylique.

### b- Dépôt d'une barrière de diffusion

Pour cette étape on a utilisé une machine Leybold L560, la pression totale des gaz durant le dépôt de la barrière de diffusion a été maintenue à 0,5 Pa. Les dépôts par pulvérisation cathodique réactive ont été réalisés à partir de cibles métalliques de Nb, Ta, Zr ou Hf avec une densité de puissance comprise entre 2,5 et 3,5 W/cm² et une concentration de diazote comprise entre 6 et 10% dans de l'argon. Cette méthode très directionnelle, de mise en oeuvre aisée, convient bien en laboratoire pour les substrats plans comme les plaquettes de fraisage, de tournage ou de rabotage. Il faut cependant noter que des machines de pulvérisation cathodique réactive industrielles peuvent être conçues pour déposer des couches uniformes sur des substrats complexes. Les dépôts par RPAE ont été réalisés par évaporation de charges métalliques de niobium ou de zirconium par canon à électrons multi creusets sous une pression totale de 0,5 Pa d'argon pur pour le décapage initial de la surface, puis d'un mélange Ar/N₂ dont la teneur variait de 95 à 100 % en di-azote selon la vitesse d'évaporation de la charge. Le porte substrat, placé à une quinzaine de centimètres au dessus du creuset, était polarisé négativement (tension RF comprise entre -500 et -1500V). Les substrats sont chauffés soit par effet joule soit par bombardement ionique de manière à obtenir une croissance colonnaire dense. Des températures comprises entre 400 et 500°C se sont révélées particulièrement adaptées car d'une part elles assurent une très bonne cohésion du substrat et de la barrière et d'autre part, situées à mi chemin entre la température ambiante et celle du procédé de diamantage, les effets des contraintes d'origine thermiques sont réduits et de ce fait aucune fissuration ni décollement n'ont été observés.

### c- Dépôt d'une couche de germination et d'accrochage

Nous avons déposé consécutivement, par les mêmes techniques que décrites au §2-b ci-dessus, et avec les mêmes paramètres (l'ajout de diazote n'étant plus nécessaire était alors interrompu) 200 nm de molybdène sur les supports de WC-Co préalablement revêtus d'une barrière nitrure.

### d- Initiation :

Au cours de cette étape, le substrat a été porté à une température de 850°C sous un plasma hyperfréquence d'hydrogène pur à la pression de 40hPa pendant 15 minutes sous un champ électrique de -200V. La densité de puissance était de 1 W/cm².

### e- Germination :

On a appliqué un plasma d'un mélange H₂/CH₄ dans lequel la concentration en méthane est portée à 3% en volume par rapport au volume total de gaz, sous une polarisation continue de -200V durant 30 minutes. La densité de puissance était également de 1W/cm². La température était de 850°C et la pression était maintenue à 40 hPa pour un débit total de 250 cm³/min.

### f- Croissance :

L'étape de croissance se déroule à 850°C et se décompose en 2 séquences : Elle comporte des phases alternées d'une durée de trente minutes chacune de coalescence sans champ électrique appliqué puis de gravure sous champ électrique négatif. Les conditions de croissance comprennent l'emploi d'un mélange constitué de 99,2% d'hydrogène, 0,8% de méthane sous une pression totale de 40 hPa et un débit total de 450 cm³/min.

La première phase de coalescence, sans champ électrique appliqué, débute juste après l'étape de germination. Durant 30 minutes, la taille des germes s'accroît et les grains formés peuvent coalescer librement. A la fin de cette phase, une tension continue de - 200V est appliquée durant 30 minutes sans rien changer aux conditions d'atmosphère gazeuse. La densité de puissance mesurée était de 1W/cm². Cette densité s'accroit pour le même potentiel appliqué au cours des phases ultérieures de gravure.

La succession de séquences est appliquée pendant une durée de 6h, la densité de puissance finale mesurée était de 8 W/cm².

### g- Enrobage tribologique :

L'enrobage tribologique est une option destinée à minimiser les effets des contraintes mécaniques et thermiques sur la tenue de la couche de diamant très sensible à l'oxydation.

Le matériau déposé doit posséder un coefficient de friction aussi faible que possible et une résistance à l'oxydation supérieure à celle du diamant.

Nous avons déposé en couche méso micronique par pulvérisation cathodique réactive et par RPAE dans les mêmes conditions que celles utilisées pour le dépôt des barrières de diffusion, des nitrures de zirconium ZrN (coefficient de friction 0,3 à 0,5), du nitrure de chrome CrN (coefficient de friction sur acier 0,4) et de l'alumine Al₂0₃ (coefficient de friction 0,4).

Les nitrures de zirconium et de chrome sont bien connus comme matériaux de traitement de surface des outils de coupe.

Par recuit à l'air à diverses températures nous avons démontré que ZrN est stable jusqu'à 500°C, température à partir de laquelle il commence à former ZrO₂. CrN est stable jusqu'à 700°C et l'alumine est bien connue pour être stable bien au delà de 1000°C. L'accrochage de l'alumine sur la couche de diamant est favorisé par le dépôt préalable à basse température d'une fine couche de titane ou de zirconium de 50 à 150 nm d'épaisseur.

### 3- Analyse :

On a étudié le substrat obtenu à l'issue des étapes 2a à 2f.

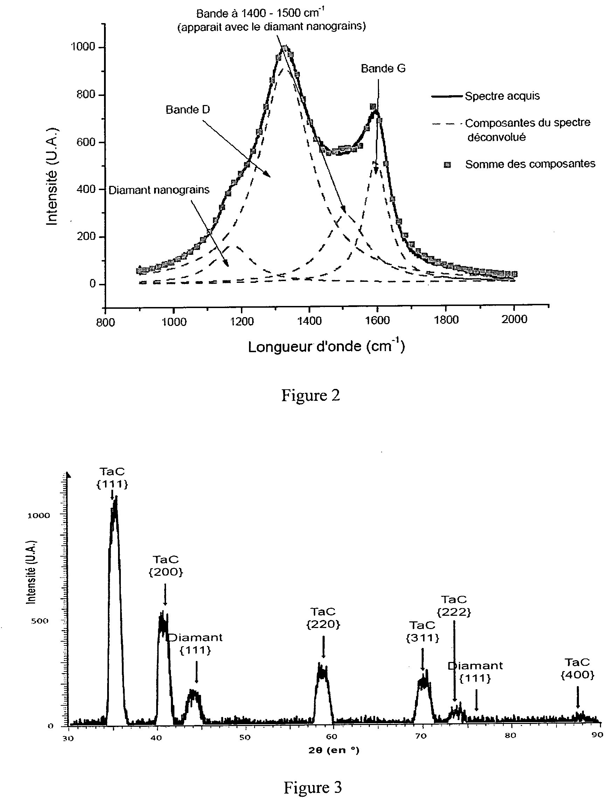

Sur la figure la on peut observer l'aspect morphologique 2D de la surface diamantée. L'aspect pyramidal du revêtement est clairement mis en évidence. Pour ce dépôt réalisé à 800°C pendant 3 heures, la couche est discontinue, les zones sombres révèlent la surface des couches interfaciales (barrière + couches d'accroche). Un grossissement plus important (figure 1b) permet de mettre en évidence la présence d'agrégats de grains nanométriques caractéristiques d'une couche de PyrNCD en se fiant à l'aspect de surface des « pyramides ». De plus, ce résultat est validé par l'analyse Raman (figure 2) qui montre clairement la présence de pics caractéristiques de grains de diamant nanométriques.

La figure 3 présente le résultat d'une analyse par diffraction sous faible incidence de rayons X de la surface du revêtement diamanté, technique permettant d'analyser le revêtement avec très peu de signal venant du substrat. En dehors de la présence évidente de diamant en surface, cette analyse permet de noter la forte texturation des couches et aussi de valider la carburation quasi-complète de la couche intermédiaire de TaN en TaC, qui n'altère en rien son effet de barrière au cobalt. La couche de Mo, trop mince pour ce type d'analyse, n'apparait pas.

Les figures 4a, 4b et 4c permettent d'observer le multi-matériau composite diamanté en coupe à différents grossissements. La couche de diamant est continue après un dépôt de 6h à 850°C. On note la présence de la couche interfaciale (TaN transformée en TaC) continue et micrométrique entre le substrat et le revêtement de diamant. La couche de molybdène de très faible épaisseur n'est pas visible alors qu'elle l'est sur d'autres analyses pratiquées sur des échantillons soumis à un dépôt à 850°C durant 3 heures seulement. Ce type d'observation met aussi en évidence la forme pyramidale du revêtement. On note la très petite taille, inférieure au 1/10 de micron des grains de diamant à proximité de la couche interface. Ceci est dû à la sursaturation en carbone au cours de la phase de germination. Sur les côtés des pyramides on observe la croissance de nano grains de diamant alors que les pyramides elles mêmes ont un aspect cristallisé très dense. Les arêtes arrondies des pyramides sont dues à l'action érosive du champ électrique. L'absence de décohésion entre les différentes couches est mise en évidence. C'est un des points forts de ce nouveau procédé.

## Revendications

1. Procédé de dépôt de diamant sur un substrat, par dépôt chimique en phase vapeur, ce procédé comprenant au moins :
a) une étape d'initiation,
b) une étape de germination,
c) une étape de croissance, l'étape de croissance comportant au moins une séquence de deux phases successives, la première phase étant une phase de coalescence sans application de champ électrique et la seconde phase étant une phase de germination par application d'un champ électrique.

2. Procédé selon la revendication 1, dans lequel le substrat est choisi parmi : un carbure de tungstène-cobalt (WC-Co), du titane, un alliage de titane.

3. Procédé selon la revendication 2, dans lequel le substrat est un carbure de tungstène-cobalt (WC-Co) comprenant de 4 à 14 % en masse de cobalt.

4. Procédé selon la revendication 3, dans lequel le substrat est préparé par application d'un traitement choisi parmi : un décapage mécanique et un décapage chimique.

5. Procédé selon l'une quelconque des revendications 1 à 4, qui comporte une étape de dépôt d'une barrière de diffusion sur le substrat, avant l'étape a).

6. Procédé selon la revendication 5, qui comprend une étape de dépôt d'une couche de germination et d'accrochage après le dépôt d'une barrière de diffusion.

7. Procédé selon l'une quelconque des revendications 1 à 6, qui est mis en oeuvre dans un réacteur à filament chaud.

8. Procédé selon l'une quelconque des revendications 1 à 7, dans lequel l'étape d'initiation consiste à porter le substrat à une température comprise entre 700 et 900°C, sous un plasma hyperfréquence d'hydrogène pur ou d'un mélange d'hydrogène et d'un gaz rare pendant une durée comprise entre 10 et 30 minutes sous un champ électrique d'un potentiel continu de -100V à - 350V

9. Procédé selon l'une quelconque des revendications 1 à 8, dans lequel l'étape de germination comporte l'application d'un champ électrique d'un potentiel continu compris entre -100V et - 350V pendant une durée comprise entre 20 et 60 minutes, en présence d'un plasma d'un mélange H₂/CH₄/X, dans lequel X représente un gaz rare ou neutre, avec un pourcentage en volume de gaz rare ou neutre par rapport au volume total du mélange compris entre 0 et 20% et avec un pourcentage en volume de CH₄ par rapport au volume total du mélange compris entre 3 et 4 %.

10. Procédé selon l'une quelconque des revendications 1 à 9, dans lequel les phases alternées de coalescence sans champ électrique puis de gravure sous champ électrique sont mises en oeuvre dans les conditions suivantes :
- durée de chaque phase comprise entre 20 et 40 minutes,
- application d'un plasma d'un gaz choisi parmi :
• un mélange H₂/CH₄/X dans lequel X représente un gaz rare ou neutre, avec un pourcentage en volume de gaz rare ou neutre par rapport au volume total du mélange compris entre 0 et 10 % et avec un pourcentage en volume de CH₄ par rapport au volume total du mélange compris entre 0,5 et 1,5 %,
• un mélange de H₂/CH₄/CO₂, volume du mélange CH₄/CO₂ par rapport au volume total des gaz compris entre 0,5 et 5% pour un rapport des volumes de CH₄/CO₂ compris entre 0,2 et 0,8,
• un mélange CH_{4/}CO₂ avec un rapport des volumes de CH₄/CO₂ compris entre 0,4 et 0,6,
- le débit total des gaz étant supérieur à 10 cm³/min, et la pression comprise entre 1 et 60 hPa.

11. Procédé selon l'une quelconque des revendications 1 à 10, dans lequel au cours de la phase de gravure on applique un champ électrique d'un potentiel continu négatif.

12. Procédé selon la revendication 11, dans lequel au cours de la phase de gravure on applique un champ électrique d'un potentiel continu de -100V à -350V.

13. Procédé selon l'une quelconque des revendications 1 à 12, qui comprend en outre une étape supplémentaire d'enrobage tribologique.

## Patentansprüche

1. Verfahren zum Abscheiden von Diamant auf einem Substrat mittels chemischer Gasphasenabscheidung, wobei dieses Verfahren mindestens Folgendes umfasst:
a) einen Einleitungsschritt,
b) einen Keimbildungsschritt,
c) einen Wachstumsschritt, wobei der Wachstumsschritt mindestens eine Abfolge von zwei aufeinanderfolgenden Phasen aufweist, wobei die erste Phase eine Koaleszenzphase ohne Anlegen eines elektrischen Felds ist und die zweite Phase eine Keimbildungsphase durch Anlegen eines elektrischen Felds ist.

2. Verfahren nach Anspruch 1, wobei das Substrat ausgewählt wird aus: einem Wolframcarbid-Cobalt (WC-Co), Titan, einer Titanlegierung.

3. Verfahren nach Anspruch 2, wobei das Substrat ein Wolframcarbid-Cobalt (WC-Co) mit 4 bis 14 Gewichts-% Cobalt ist.

4. Verfahren nach Anspruch 3, wobei das Substrat durch Anwenden einer Behandlung hergestellt wird, die ausgewählt wird aus: einer mechanischen Schichtentfernung und einer chemischen Schichtentfernung.

5. Verfahren nach einem der Ansprüche 1 bis 4, das einen Schritt zum Aufbringen einer Diffusionsbarriere auf dem Substrat vor Schritt a) aufweist.

6. Verfahren nach Anspruch 5, das einen Schritt zum Aufbringen einer Keimbildungs- und Haftschicht nach dem Aufbringen einer Diffusionsbarriere umfasst.

7. Verfahren nach einem der Ansprüche 1 bis 6, das in einem Heißdraht-Reaktor durchgeführt wird.

8. Verfahren nach einem der Ansprüche 1 bis 7, wobei der Einleitungsschritt darin besteht, das Substrat in einem Mikrowellenplasma aus reinem Wasserstoff oder einer Mischung aus Wasserstoff und einem Edelgas für eine Dauer zwischen 10 und 30 Minuten in einem elektrischen Feld mit einem Gleichspannungspotential von -100 V bis -350 V auf eine Temperatur zwischen 700 und 900 °C zu bringen.

9. Verfahren nach einem der Ansprüche 1 bis 8, wobei der Keimbildungsschritt das Anlegen eines elektrischen Felds mit einem Gleichspannungspotential von zwischen -100 V und -350 V für eine Dauer zwischen 20 und 60 Minuten in Gegenwart eines Plasmas einer Mischung H₂/CH₄/X umfasst, wobei X ein Edelgas oder Inertgas darstellt, mit einem Volumenprozentanteil des Edelgases oder Inertgases bezogen auf das Gesamtvolumen der Mischung von zwischen 0 und 20 % und mit einem Volumenprozentanteil von CH₄ bezogen auf das Gesamtvolumen der Mischung von zwischen 3 und 4 %.

10. Verfahren nach einem der Ansprüche 1 bis 9, wobei die sich abwechselnden Phasen der Koaleszenz ohne elektrisches Feld und des anschließenden Ätzens im elektrischen Feld unter folgenden Bedingungen durchgeführt werden:
- Dauer jeder Phase zwischen 20 und 40 Minuten,
- Anwenden eines Plasmas eines Gases ausgewählt aus:
• einer Mischung H₂/CH₄/X, wobei X ein Edelgas oder Inertgas darstellt, mit einem Volumenprozentanteil des Edelgases oder Inertgases bezogen auf das Gesamtvolumen der Mischung von zwischen 0 und 10 % und mit einem Volumenprozentanteil von CH₄ bezogen auf das Gesamtvolumen der Mischung von zwischen 0,5 und 1,5 %,
• einer Mischung H₂/CH₄/CO₂, Volumen der Mischung CH₄/CO₂ bezogen auf das Gesamtvolumen der Gase von zwischen 0,5 und 5 % bei einem Volumenverhältnis CH_{4/}CO₂ von zwischen 0,2 und 0,8,
• einer Mischung CH_{4/}CO₂ mit einem Volumenverhältnis CH_{4/}CO₂ von zwischen 0,4 und 0,6,
- der Gesamtvolumenstrom der Gase liegt über 10 cm³/min und der Druck zwischen 1 und 60 hPa.

11. Verfahren nach einem der Ansprüche 1 bis 10, wobei während der Ätzphase ein elektrisches Feld mit einem negativen Gleichspannungspotential angelegt wird.

12. Verfahren nach Anspruch 11, wobei während der Ätzphase ein elektrisches Feld mit einem Gleichspannungspotential von -100 V bis -350 V angelegt wird.

13. Verfahren nach einem der Ansprüche 1 bis 12, das ferner einen zusätzlichen Schritt zum tribologischen Beschichten umfasst.

## Claims

1. Process for depositing diamond on a substrate, by chemical vapor deposition, this process comprising at least:
a) an initiation step;
b) a nucleation step;
c) a growth step, the growth step comprising at least one sequence of two successive phases, the first phase being a coalescence phase without application of an electric field and the second phase being a nucleation phase with application of an electric field.

2. Process according to Claim 1, in which the substrate is chosen from: tungsten carbide-cobalt (WC-Co), titanium, or a titanium alloy.

3. Process according to Claim 2, in which the substrate is tungsten carbide-cobalt (WC-Co) comprising from 4 to 14% by weight of cobalt.

4. Process according to Claim 3, in which the substrate is prepared by application of a treatment chosen from: mechanical pickling and chemical pickling.

5. Process according to any one of Claims 1 to 4, which comprises a step of depositing a diffusion barrier on the substrate, before step a).

6. Process according to Claim 5, which comprises a step of depositing a nucleation and tie layer after the deposition of a diffusion barrier.

7. Process according to any one of Claims 1 to 6, which is carried out in a hot filament reactor.

8. Process according to any one of Claims 1 to 7, in which the initiation step consists in bringing the substrate to a temperature between 700 and 900°C, under a microwave frequency plasma of pure hydrogen or of a mixture of hydrogen and of a noble gas for a duration of between 10 and 30 minutes under an electric field with a continuous potential of -100 V to -350 V.

9. Process according to any one of Claims 1 to 8, in which the nucleation step comprises the application of an electric field with a continuous potential between -100 V and -350 V for a duration between 20 and 60 minutes, in the presence of a plasma of a H₂/CH₄/X mixture, in which X represents a noble or inert gas, with a volume percentage of noble or inert gas relative to the total volume of the mixture of between 0 and 20% and with a volume percentage of CH₄ relative to the total volume of the mixture of between 3 and 4%.

10. Process according to any one of Claims 1 to 9, in which the alternate phases of coalescence without an electric field then of etching under an electric field are carried out under the following conditions:
- duration of each phase between 20 and 40 minutes;
- application of a plasma of a gas chosen from:
• a H₂/CH₄/X mixture in which X represents a noble or inert gas, with a volume percentage of noble or inert gas relative to the total volume of the mixture of between 0 and 10% and with a volume percentage of CH₄ relative to the total volume of the mixture of between 0.5 and 1.5%;
• a H₂/CH₄/CO₂ mixture, volume of the CH₄/CO₂ mixture relative to the total volume of the gases of between 0.5 and 5% for a ratio of the volumes of CH_{4/}CO₂ of between 0.2 and 0.8;
• a CH₄/CO₂ mixture with a ratio of the volumes of CH_{4/}CO₂ of between 0.4 and 0.6;
- the total flow rate of the gases being greater than 10 cm³/min, and the pressure being between 1 and 60 hPa.

11. Process according to any one of Claims 1 to 10, in which, during the etching phase, an electric field with a negative continuous potential is applied.

12. Process according to Claim 11, in which during the etching phase, an electric field with a continuous potential of -100 V to -350 V is applied.

13. Process according to any one of Claims 1 to 12, which also comprises an additional tribological coating step.
